# EUROPÄISCHE PATENTSCHRIFT

(11) **EP 2 243 342 B1**
(45) Veröffentlichungstag und Bekanntmachung des Hinweises auf die Patenterteilung: **20.03.2019**
(21) Anmeldenummer: 08869592.9
(22) Anmeldetag: 18.12.2008
(51) Int. Cl.: H05K 3/28, H05K 3/34, H05K 1/02

(54) **ELEKTRONISCHES BAUTEIL UND VERFAHREN ZUR HERSTELLUNG DES ELEKTRONISCHEN BAUTEILES**
ELECTRONIC COMPONENT AND METHOD FOR PRODUCING SUCH AN ELECTRONIC COMPONENT
COMPOSANT ÉLECTRONIQUE ET PROCÉDÉ POUR FABRIQUER UN COMPOSANT ÉLECTRONIQUE

(30) Priorität: 10.01.2008 DE 102008003790
(43) Veröffentlichungstag der Anmeldung: 27.10.2010
(73) Patentinhaber: Robert Bosch GmbH, 70442 Stuttgart (DE)
(72) Erfinder: LEGLER, Lars, 36460 Dorndorf (DE); KRAUSE, Norbert, 99817 Eisenach (DE); SCHLIWA, Enrico, 99834 Gerstungen (DE); OTTO, Werner, 99837 Dankmarshausen (DE)
(86) Internationale Anmeldenummer: PCT/EP2008/067820
(87) Internationale Veröffentlichungsnummer: WO 2009/087035

(56) Entgegenhaltungen:
- DE-A1- 19 611 407
- DE-A1-102006 018 364
- JP-A- 10 070 376
- JP-A- 2000 340 718
- US-A- 3 501 582
- US-A1- 2005 151 229
- US-A1- 2005 161 782
- US-A1- 2005 212 113

## Beschreibung

Die Erfindung betrifft ein elektronisches Bauteil mit elektrisch leitfähigen Kontakten und einer Leiterplatte, die von einem Mantel aus einem ersten Kunststoff ummantelt ist, und ein Verfahren zur Herstellung des elektronischen Bauteiles.

Die JP 10 070376 A beschreibt eine Leiterplatine mit einem Anschlussstecker in einem Gehäuse. Ein Vergussmittel wird in das Gehäuse eingegossen, um die Leiterplatine luftdicht und korrosionsbeständig zu versiegeln. Aufgrund einer Ausnehmung oberhalb des Steckers fließt das Vergussmittel in die Umgebung. Deshalb wird der Stecker mit einer Dichtung versehen, die eine Finne aufweist und die Ausnehmung oberhalb des Steckers abdichtet. Aufgrund von Verfahrensschritten erscheint es wünschenswert, zunächst die Dichtung zu montieren und danach die Leiterplatine samt Anschlussstecker in ein Lötbad zu tauchen. Dabei ragt die Finne der Dichtung in das Lötbad. Deshalb wird die Finne weggespreizt und mittels Haltemitteln in der weggespreizten Stellung gehalten. Alternativ dazu wird bei einem zylinderförmigen Stecker die Dichtung verdreht.

Die DE 196 11 407 A1 betrifft einen Halbleiterbaustein, der als einreihiges Steckgehäuse ausgebildet ist und eine Hybridschaltungskomponente mit einem Keramiksubstrat aufweist. Eine Hülse auf der Oberfläche des Keramiksubstrates deckt Schaltungselemente der integrierten Hybridschaltungskomponente ab. Siliziumgel ist in die Hülse eingegossen, gehärtet und dient als festes Versiegelungsmaterial.

Die DE 10 2006 018364 beschreibt ein Gehäuse einer elektronischen Sende und Empfangseinrichtung für einen Schlüssel. Eine von der Bestückungsfläche abgewandte Rückseite einer Leiterplatine bildet einen Teil der Außenfläche des Gehäuses. Wenn das Gehäuse durch ein Harzgießverfahren gebildet wird, wird das Harz gegossen, während die Rückseite der Leiterplatte in engem Kontakt mit einer Wandfläche in einem Formnest der Gießform steht. Damit wird eine Verformung der Leiterplatte durch einen Druck verhindert, der beim Aushärten des Harzes entsteht.

Die US 2005/212113 A1 beschreibt eine Hybridschaltung und ein Verfahren zur Herstellung der Hybridschaltung. Das Verfahren ermöglicht eine Versiegelung, nachdem eine Mehrzahl von Leiterplatinen in einem Stanzgitter fixiert ist. In unmittelbarer Umgebung eines äußeren Kontaktstiftes ist immer ein zweiter Kontaktstift angeordnet, um eine thermische Belastung auf einen einzelnen äußeren Kontaktstift zu vermeiden. Dieser zweite Kontaktstift kann auch ein Blindflansch sein. Eine Alleinsteilung von Kontaktstiften an äußeren Rändern ist vermieden.

Die US 2005/161782 A1 beschreibt eine Hybridschaltung mit rechteckförmigen Kontaktstiften. Jeder Kontaktstift weist einen ersten sich länglich erstreckenden Teil und einen zweiten sich länglich erstreckenden Teil auf, die einteilig mit einem Bogenteil ausgeführt sind. Das erste und das zweite sich länglich erstreckende Teil nehmen im Idealfall einen rechten Winkel zueinander ein. Das erste Teil des Kontaktstiftes steht senkrecht auf einer Leiterplatine der Hybridschaltung und ist mit einer Spitze an der Leiterplatine verlötet. Während des Gießens wird die Leiterplatine in zwei Gußhälften eingebettet. Das zweite Teil des Kontaktstiftes erstreckt sich parallel einer Bestückungsoberfläche der Leiterplatine und wird während des Gießens von den beiden Gußhälften eingeklemmt, dabei wird die Rückseite der Leiterplatine gegen eine Wandfläche der Gießform gedrückt. Aufgrund der rechteckförmig zueinander angeordneten Kontaktstiftteileverbleibt auch bei auftretenden Toleranzen die Rückseite der Platine mit voller Fläche gegen die Wandfläche der Gießform gedrückt.

Die US 3 501 582 A betrifft ein Kontaktelement mit zwei sich im wesentlichen parallel erstreckenden Fingern, die eine Leiterplatine zangenförmig umgreifen und eine elektrisch leitfähige Verbindung mit zumindest einer Kontaktfläche der Leiterplatine bewerkstelligen.

Aus der US 2005/0151229 A1 ist ein elektronisches Bauteil mit einer Leiterplatte und einem Stanzgitter bekannt, die von einem Gehäuse aus einem Kunstharz getragen sind. Die Leiterplatte ist mit einem zweiten Kunstharz vergossen. Die Kunstharze sind nicht definiert, die Lage der Kunstharze zueinander ist nicht erläutert.

Aus der JP 2000 340718 A ist ein Leistungsbauteil bekannt, bei dem ein Schaltungsträger in ein becherförmiges Rahmengehäuse mit elektrischen Anschlüssen eingebracht wird und das Rahmengehäuse mit Harz ausgegossen wird.

Aus der DE 196 24 478 A1 ist ein Bauteil mit einer Leiterplatte bekannt, die mit einem Thermoplast und einem Duroplast umhüllt ist.

Derartige elektronische Bauteile der eingangs genannten Art werden in Ölwannen eines Getriebes eingesetzt. Die Kunststoffummantelung erfolgt mittels eines Duroplastes. Duroplaste, auch Duromere genannt, sind Kunststoffe, die nach ihrer Aushärtung nicht mehr verformbar und äußerst widerstandsfähig sind. Auf der Leiterplatte sind Widerstände, integrierte Schaltkreise und elektrisch leitfähigen Zuleitungen angeordnet. Die Kunststoffummantelung verhindert einen direkten Kontakt der Widerstände, der integrierten Schaltkreise sowie der elektrisch leitfähigen Zuleitungen mit dem Öl und schützt daher die auf der Leiterplatte angeordneten Widerstände und integrierten Schaltkreise vor einem elektrischen Kurzschluss. Die elektrisch leitfähigen Kontakte ragen aus der Kunststoffummantelung heraus und stellen eine elektrisch leitfähige Verbindung von den auf der Leiterplatte angeordneten Widerständen und Schaltkreisen zu einer innerhalb oder außerhalb der Ölwanne angeordneten Elektronik her. Innerhalb der Ölwanne sind die elektrisch leitfähigen Kontakte gekapselt, so dass ein elektrischer Kurzschluss verhindert ist.

Die elektrisch leitfähigen Kontakte, die als Kontaktschienen ausgebildet sind, sind Endprodukte, die aus Stanzgittern hergestellt werden. Ein Stanzgitter ist aus einem Blechteil ausgestanzt. Das Stanzgitter weist die elektrisch leitfähigen Kontaktschienen und Verbindungsstücke auf, die die Kontaktschienen in Position halten. Nach der Kunststoffummantelung werden die metallischen Verbindungsstücke entfernt. Dabei entstehen metallische Späne. Bleiben diese Späne an den Kontaktschienen haften, so wird das Öl innerhalb der Getriebewanne verschmutzt.

Die Duroplastmasse weist eine niedrige Viskosität auf und wird unter Druck in einen von zwei Werkzeughälften gebildeten Innenraum gepresst. In diesem Innenraum sind die Leiterplatte und das Stanzgitter fixiert. Das Umspritzen der Leiterplatte und des Stanzgitters mit Duroplast erfordert daher eine aufwändige Abdichtung der Werkzeughälften an ihren Stoßstellen. Besonders kritisch sind Bereiche, an denen das Stanzgitter aus der Duroplastmasse austritt. Diese Austrittsstellen fallen mit der Stoßstelle der Werkzeughälften zusammen. Die Austrittsstellen des Stanzgitters definieren die Stoßstellen der Werkzeughälften und umgekehrt. Trotz der aufwändigen Abdichtung entstehen während der Kunststoffummantelung an den Stoßstellen der Werkzeughälften, insbesondere an der Austrittsstelle des Stanzgitters, dünne Kunststofflappen, so genannte Flashhäute, die überstehen. Diese Kunststofflappen sind unerwünschte Abfallprodukte und müssen nach Fertigstellung des elektronischen Bauteiles entfernt werden. Verbleiben jedoch Reste dieser Kunststofflappen an der Kunststoffummantelung oder bleiben entfernte Kunststofflappen an den Kontaktschienen des elektronischen Bauteils haften, so wird das Öl innerhalb der Getriebewanne verschmutzt.

Die Werkzeughälften definieren an ihren Stoßstellen eine Trennebene. Die Trennebene verläuft etwa mittig des elektronischen Bauteils. Aufgrund der mittigen Trennebene ist eine Entlüftung problematisch. Während der Kunststoffummantelung entstehen Lufteinschlüsse zwischen dem Werkzeug und dem Kunststoff, die als Ausnehmungen an einer Außenfläche der Kunststoffummantelung sichtbar sind. Diese Ausnehmungen führen zu Beschädigungen der Kunststoffummantelung, so dass eine dauerhafte elektrische Isolation der Widerstände und der integrierten Halbleiter aufgrund dieser Ausnehmungen nicht gegeben ist.

Der Erfindung liegt die Aufgabe zugrunde, ein einfaches Verfahren und ein einfaches elektronisches Bauteil zum Betrieb in einer Ölwanne eines Getriebes anzugeben. Die elektrische Isolation von auf der Leiterplatte angeordneten Widerständen und Schaltkreisen soll gewährleistet sein. Das Öl innerhalb der Getriebewanne soll von metallischen Spänen und Kunststoffüberresten des elektronischen Bauteils nicht verschmutzt werden. Lufteinschlüsse sollen vermieden sein.

Diese Aufgaben werden mit den Merkmalen der Hauptansprüche gelöst. Erfindungsgemäß sind die elektrisch leitfähigen Kontakte von einem Rahmen aus einem zweiten Kunststoff umhüllt. Der Rahmen aus einem zweiten Kunststoff dient als Hilfsmittel, um das elektronische Bauteil einfacher herstellen zu können. Während der Ummantelung mit dem ersten Kunststoff liegen die Werkzeughälften zumindest bereichsweise auf dem Rahmen aus dem zweiten Kunststoff auf. Ein direkter Kontakt zwischen den Werkzeughälften und dem Stanzgitter ist vermieden. Der Kunststoffrahmen ist ein hervorragend geeignetes Abdichtungsmittel für die Werkzeughälften. Flashhäute, die während der Kunststoffummantelung an den Austrittsstellen des Stanzgitters entstehen, sind vermieden. Zudem ist der Kunststoffrahmen leicht zu bearbeiten. Kanäle für einen Anguss und für eine Entlüftung werden im Rahmen aus dem zweiten Kunststoff ausgeformt. Als Anguss ist der Kanal im Rahmen bezeichnet, der zur Befüllung der Werkzeughälften dient. Eine Entlüftung ist verteilt über den gesamten Umfang des Rahmens an zwei aneinander abgewandten Oberflächen des Rahmens durchführbar.

Zur einfachen Herstellung des elektronischen Bauteils sind folgende Verfahrensschritte angewandt: ein Gitter mit elektrisch leitfähigen Kontakten und mit Verbindungstücken wird hergestellt, das Gitter wird in einem Rahmen aus einem zweiten Kunststoff fixiert, die Verbindungstücke des Gitters werden entfernt, die Leiterplatte wird in den Rahmen ein- und auf die elektrisch leitfähigen Kontakte des Gitters aufgesetzt und die Leiterplatte wird von dem ersten Kunststoff ummantelt.

In vorteilhafter Weise umrahmt der Rahmen aus dem zweiten Kunststoff die Leiterplatte. Wird die gesamte Leiterplatte umrahmt, so sind die Stoßflächen der Werkzeughälften über ihren gesamten Umfang mittels des Rahmens voneinander trennbar und mittels des Rahmens abdichtbar.

In vorteilhafter Weise sind Rahmenflächen von Rahmenteilen Umfangsflächen der Leiterplatte zugewandt. Die Leiterplatte ist auf ihrer Bestückungsoberfläche mit Widerständen und integrierten Schaltkreisen bestückt. Eine Ausdehnung senkrecht zu der Bestückungsoberfläche ist geringer als eine Ausdehnung parallel der Umfangsflächen bezogen auf das Gesamtteil aus Leiterplatte, Widerständen und integrierten Schaltkreisen. In dieser senkrechten Richtung ergibt sich somit ein geringstes Volumen des Rahmens und somit eine Materialersparnis.

In vorteilhafter Weise ist der Rahmen zu der Leiterplatte beabstandet. Damit ist die Leiterplatte vollständig von dem ersten Kunststoff ummantelbar.

In vorteilhafter Weise ist der Abstand zwischen dem Rahmen und der Leiterplatte mittels der elektrisch leitfähigen Kontakte definierbar. Die elektrisch leitfähigen Kontakte sind im Rahmen fixiert. Endstücke der elektrisch leitfähigen Kontakte werden durch Öffnungen der Leiterplatte geführt, so dass die Leiterplatte bezüglich des Rahmens positioniert ist. In vorteilhafter Weise ist der zweite Kunststoff ein Thermoplast. Thermoplaste sind Kunststoffe, die über einem bestimmten Temperaturbereich verformbar sind. Dieser Vorgang ist reversibel, das heißt, er kann durch Abkühlung und Wiedererwärmung bis in den schmelzflüssigen Zustand beliebig oft wiederholt werden. Dabei ist zu beachten, dass durch Überhitzung keine thermische Zersetzung des Materials erfolgt. Darin unterscheiden sich Thermoplaste von den Duroplasten und Elastomeren. Thermoplaste lassen sich in einfacher Weise bearbeiten, Kanäle sind auf einfache Weise herstellbar.

Der Thermoplast stellt keine Barriere gegen Getriebeöl dar, es dient der Formgebung des Duroplasts, einer Vorpositionierung des Stanzgitters und einer Vermeidung der mechanischen Nacharbeitung des Duroplastes. Es entstehen keine Überstände wie Lappen oder Flashhäute. Das elektronische Bauteil ist in einer rauen Umgebung einsetzbar.

In vorteilhafter Weise schließt die Ummantelung aus dem ersten Kunststoff mit dem Rahmen aus dem zweiten Kunststoff bündig ab. Damit ist eine einfache und sichere Entlüftung erzielbar.

In vorteilhafter Weise sind die Verbindungsstücke innerhalb und außerhalb des Rahmens angeordnet. Damit ist eine sichere Positionierung der Kontaktschienen erzielbar.

In vorteilhafter Weise weist der Rahmen Vorsprünge auf. Die Vorsprünge in Form von Nasen und Noppen dienen zur Zentrierung und Positionierung des elektronischen Bauteiles in einer Aufnahmevorrichtung, etwa einem weiteren umhüllenden Kunststoff oder einer metallischen Aufnahmevorrichtung der Ölgetriebewanne.

Zum besseren Verständnis der Erfindung ist nachfolgend ein Ausführungsbeispiel anhand der Zeichnung näher erläutert.

Es zeigen
- Fig. 1: ein Stanzgitter mit elektrisch leitfähigen Kontakten und Verbindungsstücken in Draufsicht,
- Fig. 2: das Stanzgitter mit den elektrisch leitfähigen Kontakten und den Verbindungsstücken in Seitenansicht,
- Fig. 3: das in einem Kunststoffrahmen fixierte Stanzgitter von den Verbindungsstücken befreit in Draufsicht,
- Fig. 4: das in dem Kunststoffrahmen fixierte Stanzgitter von den Verbindungsstücken befreit in Seitenansicht,
- Fig. 5: eine in den Rahmen ein- und auf das Stanzgitter aufgesetzte Leiterplatte in Draufsicht,
- Fig. 6: die in den Rahmen ein- und auf das Stanzgitter aufgesetzte Leiterplatte in Schnittdarstellung von der Seite,
- Fig. 7: ein elektronisches Bauteil mit einem die Leiterplatte ummantelnden Kunststoff in Draufsicht und
- Fig. 8: das elektronische Bauteil mit dem die Leiterplatte ummantelnden Kunststoff in Seitenansicht.

In den verschiedenen Figuren sind ähnliche oder dieselben Elemente durch gleiche Bezugszeichen bezeichnet.

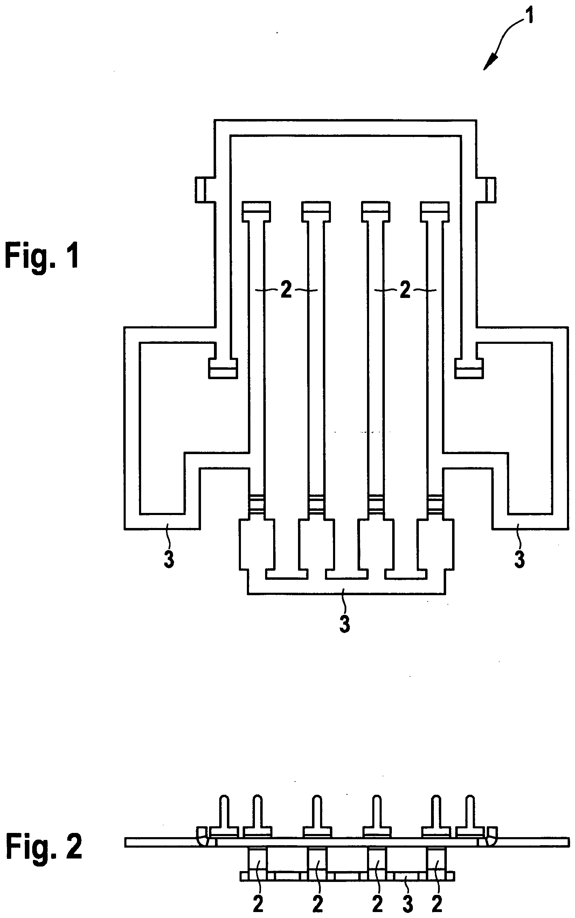

Figuren 1 und 2 zeigen ein aus einem Blech ausgestanztes und vorgeformtes Teil 1, nachfolgend als Stanzgitter bezeichnet. Das Stanzgitter 1 ist aus einem elektrisch leitfähigen Material hergestellt und weist elektrisch leitfähige Kontakte 2 in Form von Kontaktschienen auf. Die elektrisch leitfähigen Kontaktschienen 2 sind mittels Verbindungsstücken 3 verbunden und in Position gehalten.

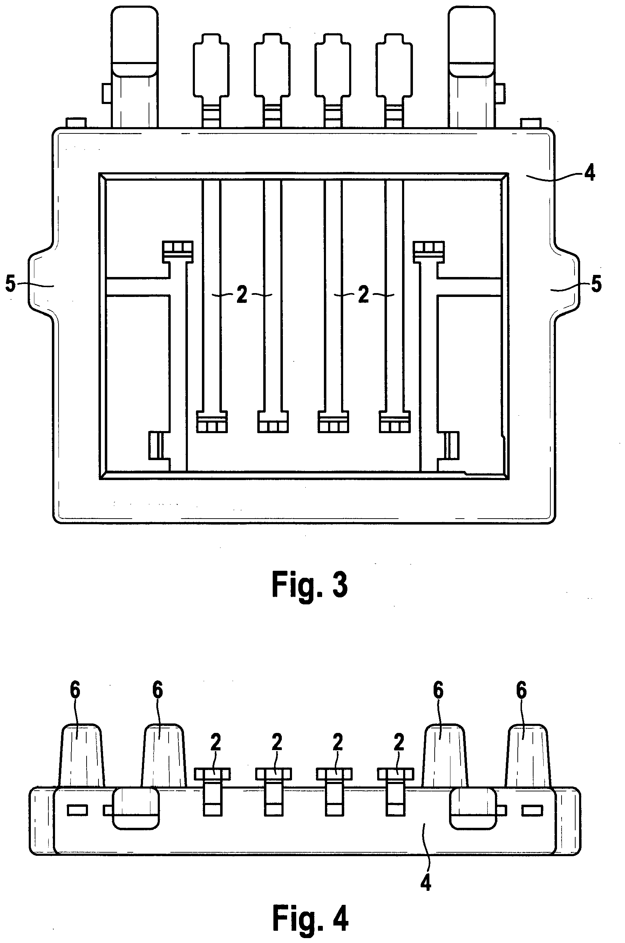

Figuren 3 und 4 zeigen die elektrisch leitfähigen Kontaktschienen 2 fixiert in einem Rahmen 4 aus einem zweiten Kunststoff. Der Rahmen 4 umhüllt die elektrisch leitfähigen Kontaktschienen bereichsweise. Die Verbindungsstücke 3 des Stanzgitters 1 sind entfernt, so dass die Kontaktschienen 2 untereinander elektrisch isoliert und fixiert von dem Rahmen 4 in Position gehalten sind. Vorsprünge in Form von Nasen 5 und Noppen 6 dienen zur Zentrierung und Fixierung des Rahmens 4.

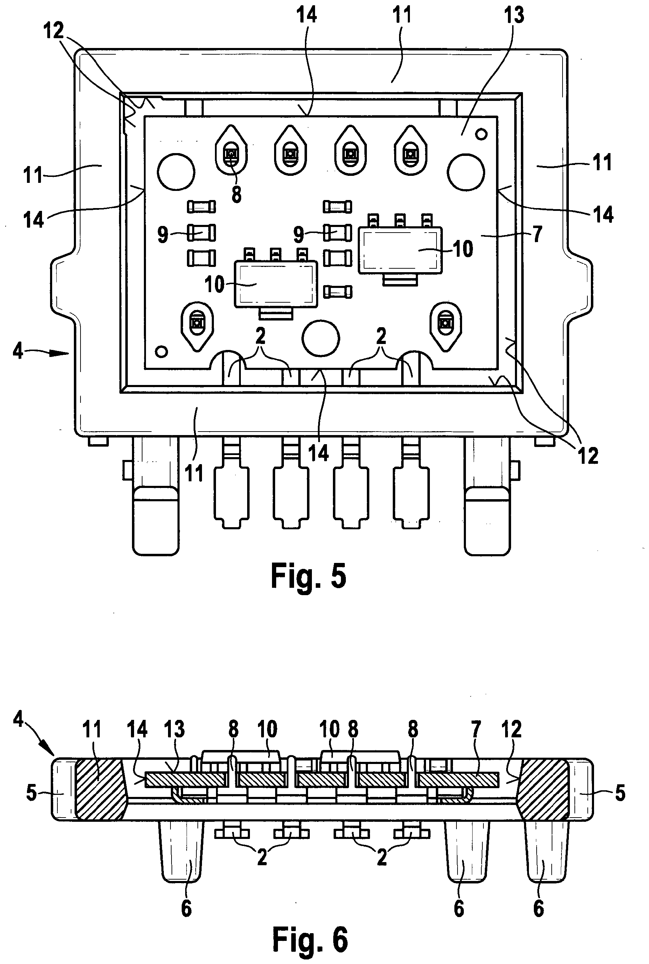

Figuren 5 und 6 zeigen eine Leiterplatte 7 aufgesetzt auf die elektrisch leitfähigen Kontaktschienen 2. Endstücke 8 der elektrisch leitfähigen Kontaktschienen 2 durchstoßen Öffnungen der Leiterplatte 7 und sind mit Leiterbahnen auf der Leiterplatte 7, auch als Leiterplatine bezeichnet, elektrisch leitfähig verbunden. Die Leiterplatte 7 weist Widerstände 9 und integrierte Schaltkreise 10 auf. Die integrierten Schaltkreise 10 sind Hallelemente. Die Hallelemente 10 dienen zur Feststellung der Position eines Gangwahlhebels. Die Leiterplatte 7 ist zu dem Kunststoffrahmen 4 beabstandet. Der Rahmen 4 weist vier längliche Rahmenteile 11 auf, von denen jeweils zwei parallel zueinander angeordnet sind. Jeweils eines der Rahmenteile 11 weist eine nach innen ausgerichtete Oberfläche 12 auf. Die Leiterplatte 7 weist eine Bestückungsoberfläche 13, auf der die Widerstände 9 und die Hallelemente 10 angeordnet sind, und Umfangsflächen 14 auf, die senkrecht zu der Bestückungsoberfläche 13 angeordnet sind. Jeweils eine der nach innen ausgerichteten Rahmenoberfläche 12 ist einer Umfangsfläche 14 der Leiterplatte 7 zugewandt.

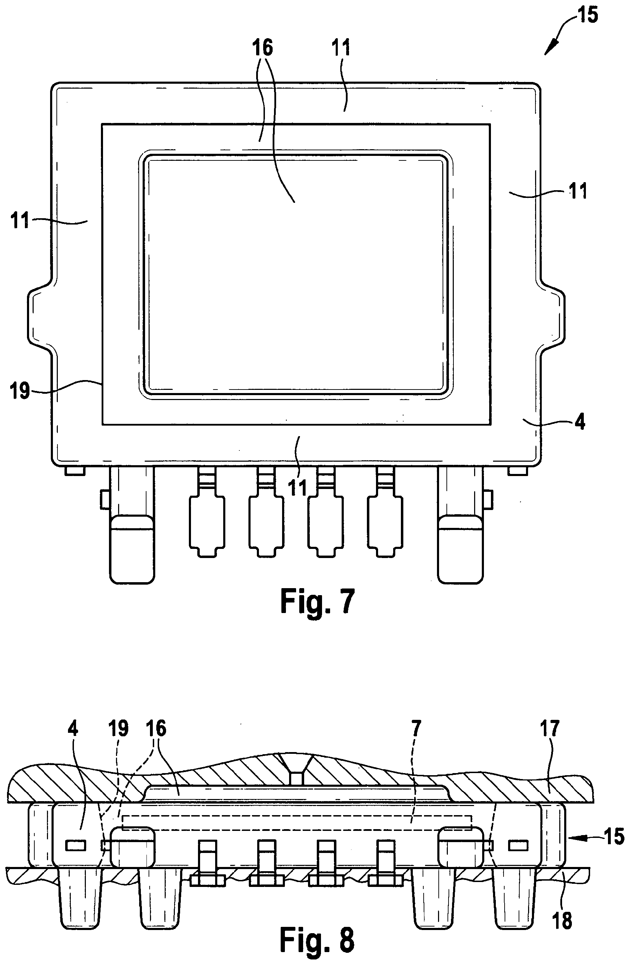

Figuren 7 und 8 zeigen ein elektronische Bauteil 15 mit dem Rahmen 4 aus dem zweiten Kunststoff und einen die Leiterplatte 7 ummantelnden Mantel 16 aus einem ersten Kunststoff. Der erste Kunststoff ist ein Duroplast, der zweite Kunststoff ist ein Thermoplast. Das Material aus dem der Mantel 16 hergestellt ist, ist der erste Kunststoff, also ein Duroplast. Das Material, aus dem der Rahmen 4 hergestellt ist, ist der zweite Kunststoff, also ein Thermoplast. Werkzeughälften 17, 18 eines Werkzeuges, das zur Ummantelung der Leiterplatte 7 und der Kontaktschienen 2 dient, liegen auf dem Rahmen 4 so auf, dass der Mantel 16 und der Rahmen 4 an einer Nahtstelle 19 bündig abschließen.

## Patentansprüche

1. Elektronisches Bauteil (15) mit elektrisch leitfähigen Kontakten (2) und einer Leiterplatte (7), die von einem Mantel (16) aus einem ersten Kunststoff, nämlich Duroplast, ummantelt ist,
**dadurch gekennzeichnet, dass**
ein Rahmen (4) aus einem zweiten Kunststoff, nämlich Thermoplast, die Leiterplatte (7) umrahmt und die elektrisch leitfähigen Kontakte (2) von dem Rahmen (4) aus dem zweiten Kunststoff bereichsweise umhüllt sind, wobei in dem Rahmen (4) Kanäle für einen Anguss und für eine Entlüftung ausgeformt sind, und die Leiterplatte durch den Kanal für den Anguss in dem Rahmen mit dem ersten Kunststoff vollständig ummantelt ist.

2. Bauteil nach Anspruch 1, **dadurch gekennzeichnet, dass** Rahmenflächen (12) von Rahmenteilen (11) Umfangsflächen (14) der Leiterplatte (7) zugewandt sind.

3. Bauteil nach Anspruch 1, **dadurch gekennzeichnet, dass** der Rahmen (4) zu der Leiterplatte (7) beabstandet ist.

4. Bauteil nach Anspruch 3, **dadurch gekennzeichnet, dass** ein Abstand zwischen dem Rahmen (4) und der Leiterplatte (7) mittels der elektrisch leitfähigen Kontakte (2) positioniert ist.

5. Bauteil nach Anspruch 1, **dadurch gekennzeichnet, dass** der Mantel (16) aus dem ersten Kunststoff mit dem Rahmen (4) aus dem zweiten Kunststoff bündig abschließt.

6. Bauteil nach Anspruch 1, **dadurch gekennzeichnet, dass** der Rahmen (4) Vorsprünge (5, 6) aufweist.

7. Verfahren zur Herstellung eines elektronischen Bauteiles (15) mit elektrisch leitfähigen Kontakten (2) und einer Leiterplatte (7), die von einem Mantel (16) aus einem ersten Kunststoff, nämlich einem Duroplast ummantelt ist, in folgenden Verfahrensschritten:
- ein Gitter (1) mit elektrisch leitfähigen Kontakten (2) und mit Verbindungstücken (3) wird hergestellt,
- das Gitter (1) wird in einem Rahmen (4) aus einem zweiten Kunststoff, nämlich einem Thermoplast -fixiert,
- die Verbindungstücke (3) des Gitters werden entfernt,
- die Leiterplatte (7) wird in den Rahmen (4) ein- und auf die elektrisch leitfähigen Kontakte (2) des Gitters (1) aufgesetzt und
- die Leiterplatte (7) wird von dem ersten Kunststoff ummantelt, wobei Werkzeughälften (17, 18) zumindest bereichsweise auf dem Rahmen (4) aus dem zweiten Kunststoff aufliegen und gegen den Rahmen abdichten,
wobei der Rahmen aus dem zweiten Kunststoff die gesamte Leiterplatte umrahmt, so dass die Stoßflächen der Werkzeughälften über ihren gesamten Umfang mittels des Rahmens voneinander trennbar und mittels des Rahmens abdichtbar sind,
wobei in dem Rahmen (4) einen Anguss und eine Entlüftung bildende Kanäle ausgebildet sind, und die Werkzeughälften (17, 18) zur Ummantelung der Leiterplatte (7) durch die Kanäle in dem Rahmen (4) mit dem zweiten Kunststoff befüllt werden.

8. Verfahren nach Anspruch 7,
wobei eine Entlüftung über den gesamten Umfang des Rahmens (4) an zwei aneinander abgewandten Oberflächen des Rahmens (4) verteilt durchgeführt wird.

## Claims

1. Electronic component (15) with electrically conductive contacts (2) and with a circuit board (7) which is encased by a casing (16) composed of a first plastic, specifically thermoset,
**characterized in that**
a frame (4) composed of a second plastic, specifically thermoplastic, borders the circuit board (7) and the electrically conductive contacts (2) are regionally enveloped by the frame (4) composed of the second plastic, wherein channels for a gate and for a vent are formed in the frame (4), and the circuit board is fully encased with the first plastic through the channel for the gate in the frame.

2. Component according to Claim 1, **characterized in that** frame surfaces (12) of frame parts (11) face toward circumferential surfaces (14) of the circuit board (7).

3. Component according to Claim 1, **characterized in that** the frame (4) is spaced apart from the circuit board (7).

4. Component according to Claim 3, **characterized in that** a spacing between the frame (4) and the circuit board (7) is positioned by means of the electrically conductive contacts (2).

5. Component according to Claim 1, **characterized in that** the casing (16) composed of the first plastic terminates flush with the frame (4) composed of the second plastic.

6. Component according to Claim 1, **characterized in that** the frame (4) has projections (5, 6).

7. Method for producing an electronic component (15) with electrically conductive contacts (2) and with a circuit board (7) which is encased by a casing (16) composed of a first plastic, specifically a thermoset, in the following method steps:
- a lattice (1) with electrically conductive contacts (2) and with connecting pieces (3) is produced,
- the lattice (1) is fixed in a frame (4) composed of a second plastic, specifically a thermoplastic,
- the connecting pieces (3) of the lattice are removed,
- the circuit board (7) is mounted into the frame (4) and onto the electrically conductive contacts (2) of the lattice (1), and
- the circuit board (7) is encased by the first plastic, wherein tool halves (17, 18) lie at least regionally on the frame (4) composed of the second plastic and seal against the frame,
wherein the frame composed of the second plastic borders the entire circuit board, such that the joint surfaces of the tool halves are separable from one another over their entire circumference by means of the frame and are sealable by means of the frame,
wherein, in the frame (4), there are formed channels which form a gate and a vent, and the tool halves (17, 18) are, for the encasing of the circuit board (7), filled with the second plastic through the channels in the frame (4) .

8. Method according to Claim 7,
wherein a vent is led through over the entire circumference of the frame (4) in a manner distributed on two mutually averted surfaces of the frame (4).

## Revendications

1. Composant électronique (15) comprenant des contacts (2) électriquement conducteurs et un circuit imprimé (7) qui est enveloppé par une enveloppe (16) en une première matière plastique, à savoir du Duroplast, **caractérisé en ce que**
un cadre (4) en une deuxième matière plastique, à savoir du thermoplastique, encadre le circuit imprimé (7) et les contacts (2) électriquement conducteurs sont enrobés dans certaines zones par le cadre (4) en la deuxième matière plastique, des canaux pour un culot d'injection et pour une purge d'air étant façonnés dans le cadre (4), et le circuit imprimé étant entièrement enveloppé avec la première matière plastique à travers le canal pour le culot d'injection dans le cadre.

2. Composant selon la revendication 1, **caractérisé en ce que** des surfaces de cadre (12) de parties de cadre (11) font face aux surfaces périphériques (14) du circuit imprimé (7).

3. Composant selon la revendication 1, **caractérisé en ce que** le cadre (4) est espacé par rapport au circuit imprimé (7).

4. Composant selon la revendication 3, **caractérisé en ce qu'**un écart entre le cadre (4) et le circuit imprimé (7) est positionné au moyen des contacts (2) électriquement conducteurs.

5. Composant selon la revendication 1, **caractérisé en ce que** l'enveloppe (16) en la première matière plastique se termine à fleur du cadre (4) en la deuxième matière plastique.

6. Composant selon la revendication 1, **caractérisé en ce que** le cadre (4) possède des parties saillantes (5, 6) .

7. Procédé de fabrication d'un composant électronique (15) comprenant des contacts (2) électriquement conducteurs et un circuit imprimé (7) qui est enveloppé par une enveloppe (16) en une première matière plastique, à savoir du Duroplast, comprenant les étapes de procédé suivantes :
- une grille (1) comprenant des contacts (2) électriquement conducteurs et comprenant des pièces de liaison (3) est fabriquée,
- la grille (1) est fixée dans un cadre (4) en une deuxième matière plastique, à savoir du thermoplastique,
- les pièces de liaison (3) de la grille sont retirées,
- le circuit imprimé (7) est inséré dans le cadre (4) et posé sur les contacts (2) électriquement conducteurs de la grille (1) et
- le circuit imprimé (7) est enrobé par la première matière plastique, des moitiés d'outil (17, 18) reposant au moins dans certaines zones sur le cadre (4) en la deuxième matière plastique et réalisant l'étanchéité par rapport au cadre,
le cadre en la deuxième matière plastique encadrant la totalité du circuit imprimé, de sorte que les surfaces d'about des moitiés d'outil peuvent être séparées l'une de l'autre au moyen du cadre et peuvent être rendues étanches au moyen du cadre sur tout leur pourtour,
des canaux formant un culot d'injection et une purge d'air étant formés dans le cadre (4), et les moitiés d'outil (17, 18) étant remplies avec la deuxième matière plastique à travers les canaux dans le cadre (4) en vue d'envelopper le circuit imprimé (7).

8. Procédé selon la revendication 7, une purge d'air étant effectuée de manière partagée sur la totalité du pourtour du cadre (4) en deux surfaces du cadre (4) opposées l'une à l'autre.
